**Europäisches Patentamt**

**European Patent Office**

**Office européen des brevets**

(19)

(11) Veröffentlichungsnummer: **0 090 067 B2**

(12)      # NEUE EUROPÄISCHE PATENTSCHRIFT

(45) Veröffentlichungstag der neuen Patentschrift:
**20.03.91 Patentblatt 91/12**

(51) Int. Cl.[5]: **C23F 4/00**, **H01J 37/32**,
**// H01L21/302**

(21) Anmeldenummer: **82102719.0**

(22) Anmeldetag: **31.03.82**

---

(54) **Reaktor für das reaktive Ionenätzen und Ätzverfahren.**

---

(43) Veröffentlichungstag der Anmeldung:
**05.10.83 Patentblatt 83/40**

(45) Bekanntmachung des Hinweises auf die
Patenterteilung:
**23.07.86 Patentblatt 86/30**

(45) Bekanntmachung des Hinweises auf die
Entscheidung über den Einspruch:
**20.03.91 Patentblatt 91/12**

(84) Benannte Vertragsstaaten:
**DE FR GB IT**

(56) Entgegenhaltungen:
**EP-A- 0 003 020**
**EP-A- 0 065 277**
**CH-A- 551 498**
**CH-A- 682 754**
**DE-A- 2 243 708**
**DE-A- 2 722 708**
**Thin Solid Films, 33 (1976), Seiten 331-339;**
**Solid State Technology, April 1982, Seiten
166-170;**
**Yasuhiro Horiike, "High Rate Reactive Ion
Etching Using Magnetron Discharge", ET
Electrotech Seminar, Jan. 81, Hawaii;**
**Journal of Vacuum Science and Technology,
Bd. 17, Nr. 6, Nov.-Dez. 80, Seiten 1320-1325;**

(73) Patentinhaber: **IBM DEUTSCHLAND GMBH**
**Pascalstrasse 100**
**W-7000 Stuttgart 80 (DE)**
**DE**
Patentinhaber: **International Business
Machines Corporation
Old Orchard Road
Armonk, N.Y. 10504 (US)**
**FR GB IT**

(72) Erfinder: **Brandeis, Christine, Ing. grad.
Wolfstrasse 30
W-7032 Sindelfingen (DE)**
Erfinder: **Kempf, Jürgen, Dr., Dipl.-Phys.
Friesenweg 9
W-7036 Schönaich (DE)**
Erfinder: **Kraus, Georg
Im Heinental 70
W-7277 Wildberg 4 (DE)**
Erfinder: **Künzel, Ulrich, Dr., Dipl.-Chem.
August-Lämmle-Strasse 8
W-7404 Kusterdingen (DE)**

(74) Vertreter: **Mönig, Anton, Dipl.-Ing.
IBM Deutschland GmbH Patentwesen und
Urheberrecht Schönaicher Strasse 220
W-7030 Böblingen (DE)**

EP 0 090 067 B2

## Beschreibung

Silicium beispielsweise ist ein Material, welches in einer Chlor und Helium enthaltenden Atmosphäre ein überwiegend chemisch ätzbares Material ist. Wird Silicium oder beispielsweise ein Siliciumplättchen im Reaktor für das reaktive Ionenätzen einer Chlor und Helium enthaltenden Atmosphäre ausgesetzt, wobei aus dem reaktiven Gas ein Plasma erzeugt wird, so bildet sich an der Siliciumoberfläche ein $SiCl_2$-Film. Die $SiCl_2$-Radikale werden physikalisch entfernt aufgrund der zerstäubenden Wirkung der auftreffenden ionisierten Teilchen. Die $SiCl_2$-Radikale reagieren im Plasma zu $SiCl_4$ und werden abgepumpt. Die Ätzung erfolgt streng anisotrop, d.h. genau senkrecht zur zu ätzenden Oberfläche. Im Gegensatz dazu wird beispielsweise $SiO_2$ unter diesen Bedingungen überwiegend physikalisch geätzt (Kathodenzerstäubungsätzen).

Das reaktive Ionenätzen ist nicht nur vorteilhaft, weil es eine streng anisotrope Ätzung ermöglicht, sondern auch – dieser Vorteil gilt insbesondere gegenüber dem naßchemischen Ätzen – weil bei seiner Anwendung die Verunreinigung der zu ätzenden Teile vernachlässigbar gering ist.

Weil bei den bekannten Reaktoren für das reaktive Ionenätzen die zerstäubende und die chemische Ätzwirkung über den Brennzustand des Plasmas miteinander gekoppelt sind, ist es, wenn ein Material in Gegenwart eines anderen geätzt wird, das dabei möglichst wenig angegriffen werden soll, beim reaktiven Ionenatzen oft ein Problem, ein gewünschtes Ätzratenverhältnis einzustellen. Dieses Problem tritt auch dann auf, wenn das gewählte reaktive Gas das eine Material überwiegend chemisch und das andere überwiegend physikalisch ätzt.

Es ist die Aufgabe der Erfindung, einen Reaktor zum reaktiven Ionenätzen, bei dem die zerstäubende und die chemische Ätzwirkung entkoppelt sind, und ein Verfahren zum Ätzen unter Verwendung eines solchen Reaktors anzugeben, um eine überwiegend chemisch und eine überwiegend physikalisch ätzbares Material nebeneinander mit zweckgemäßen Geschwindigkeiten zu ätzen.

Diese Aufgabe wird mit einem Reaktor der eingangs genannten Art mit den Merkmalen des kennzeichnenden Teils des Patentanspruchs 1 und mit einem Verfahren der eingangs genannten Art mit den Merkmalen des kennzeichnenden Teils des Patentanspruchs gelöst.

Der erfindungsgemäße Reaktor ist insbesondere dann einsetzbar, wenn ein überwiegend chemisch ätzbares Material in Gegenwart eines überwiegend physikalisch ätzbaren Materials wesentlich stärker als das letztere geätzt werden soll. Dabei wird in vorteilhafter Weise so vorgegangen, daß die zu ätzenden Substrate über die Ebene der Kathodenoberfläche angehoben werden. Über das Anheben der Substrate läßt sich die kinetische Energie der auf dem Substrat ankommenden Ionen und Elektronen beeinflussen. Werden die Substrate beispielsweise so hoch angehoben, daß sie sich oberhalb des Dunkelraums über der Kathodenoberfläche befinden, so erniedrigt sich, wenn man unter denselben Bedingungen wie beim reaktiven Ionenätzen gemäß dem Stand der Technik, d.h. ohne die Anlegung eines lokalen Magnetfeldes, arbeitet, die Ätzgeschwindigkeit ganz drastisch, da die Teilchen, bevor sie auf den Substraten auftreffen, nur noch eine sehr geringe Spannungsdifferenz durchlaufen und deshalb eine entsprechend niedrige kinetische Energie aufweisen. Werden jedoch die Substrate erfindungsgemäß zusätzlich einem lokalen Magnetfeld unterworfen, so läßt sich die durch die Anhebung verursachte Verminderung der Ätzgeschwindigkeit bei den überwiegend chemisch ätzbaren Materialien praktisch wieder vollständig rückgängig machen, jedoch bei den überwiegend physikalisch ätzbaren Materialien nur auf einen Wert anheben, welcher um den Faktor 3 bis 4 kleiner ist als die Ätzgeschwindigkeit dieser Materialien wenn die Substrate nicht angehoben, werden. Dieser durch das Zusammenwirken der Anhebung und der Anlegung des Magnetfelds erzielte Effekt bringt genau das erwünschte Ergebnis, daß nämlich das überwiegend chemisch ätzbare Material wesentlich stärker geätzt wird als das überwiegend physikalisch ätzbare Material. Bei dieser Ausführungsform des erfindungsgemäßen Reaktors und des erfindungsgemäßen Ätzverfahrens wird eine Besonderheit der bekannten Reaktoren für das reaktive Ionenätzen umgangen, die darin besteht, daß die zerstäubende und die chemische Wirkung beim reaktiven Ionenätzen über den Brennzustand des Plasmas miteinander gekoppelt sind. Bei den bekannten Reaktoren kann weder die eine noch die andere Wirkung beeinflußt werden, ohne daß sich dabei auch gleichzeitig die andere Wirkung verändert.

Bei Anwendung des erfindungsgemäßen Reaktors läßt sich darüber hinaus eine höhere Ätzgeschwindigkeit erreichen als dies beim Stand der Technik möglich war. Die Gleichmäßigkeit der Ätzung ist genauso gut wie bei der Anwendung der bekannten Verfahren unter Verwendung der bekannten Reaktoren. Die Feldlinien der auf die Substrate wirkenden Magnetfelder können senkrecht und/oder parallel zu den Substratoberfächen verlaufen. Magnetfelder, deren magnetische Induktion in der Größenordnung von $5 \times 10^{-2}$ T liegt, erhöhen die Ätzgeschwindigkeit der überwiegend chemisch ätzbaren Materialien etwa um den Faktor 1,2. Die überwiegend physikalisch ätzbaren Materialien werden, wenn die Feldlinien parallel zur Substratoberfläche verlaufen, auch etwa um den Faktor 1,2 und wenn die Feldlinien senkrecht zur Substratoberfläche verlaufen etwa um den Faktor 2 schneller geätzt. Das Magnetfeld mit den zur Substratoberfläche parallelen Feldlinien bewirkt eine Änderung des Einfallwinkels und der Bahnform (Zyklotron-Effekt) der Ionen und

Die Erfindung betrifft einen Reaktor zum reaktiven Ionenätzen gemäß dem ersten Teil des Anspruchs 1 und ein Verfahren zum Ätzen von Substraten unter Verwendung eines solchen Reaktors, bei dem die Substrate den in einem aus einem reaktiven Gas erzeugten Plasma hergestellten ionisierten Teilchen ausgesetzt sind. Ein solcher Reaktor und ein solches Verfahren gehören zum Stand der Technik durch den Vortrag von Y. Horiike : "High Rate Reactive Ion Etching Using Magnetron Discharge" gehalten im Januar 1982 und abgedruckt in "Solid State Technology", April 1982, Seiten 166-170.

Einen Artikel, welcher sich mit der Kinetik des reaktiven Ionenätzens befaßt, haben J. L. Mauer und J. S. Logan unter dem Titel "Reactant supply in reactive ion etching" in dem Journal of Vac. Sci. Technol. 16(2), März/ April 1979, S. 404 ff. veröffentlicht. Ferner ist ein in US-A-3 994793 beschriebener Reaktor für das reaktive Ionenätzen ist zum Ätzen von flachen Substraten, wie z.B. Halbleiterplättchen, geeignet. In dem Reaktor bildet das Gehäuse die Anode, und zwischen Anode und Kathode wird während des Ätzens ein aus den in den Reaktor eingeleiteten reaktiven Gasen erzeugtes Plasma aufrechterhalten. Es ist zwar auch möglich, daß als Anode eine mit dem Gehäuse leitend verbundene und parallel zu der Kathode angeordnete Platte verwendet wird, jedoch ist, wenn das Gehäuse als Anode verwendet wird, die Anodenfläche größer als die Kathodenfläche. Dies ist ein Vorteil, weil je größer das Flächenverhältnis von Anode zu Kathode ist, desto größer der Spannungsabfall an der Kathode ist, und ein großer Spannungsabfall an der Kathode bedeutet eine hohe kinetische Energie der auf der Kathode – bzw. auf den auf der Kathode liegenden Substraten – auftreffenden ionisierten Teilchen. Beim reaktiven Ionenätzen, welches bevorzugt dann angewandt wird, wenn Löcher mit exakt vertikalen Wänden geätzt werden sollen, sind neben einer großen mittleren freien Weglänge der ionisierten Teilchen, was durch einen entsprechend kleinen Druck in der Reaktionskammer erreicht wird, ionisierte Teilchen mit einer hohen kinetischen Energie wünschenswert. Beim reaktiven Ionenätzen erfolgt der Abtrag einerseits physikalisch, d.h. aufgrund der kinetischen Energie der auftreffenden ionisierten Teilchen und andererseits chemisch, d.h. aufgrund einer Reaktion der im Plasma gebildeten ionisierten Teilchen mit dem zu ätzenden Material (ioneninduziertes chemisches Ätzen). Je nachdem, welcher der beiden Vorgänge geschwindigkeitsbestimmend beim Abtrag eines bestimmten Materials ist, spricht man von einem überwiegend physikalisch oder einem überwiegend chemisch ätzbaren Material.

Elektronen des Plasmas. Dabei erhöht sich die Wahrscheinlichkeit der Ionisierung der Teilchen und ihre kinetische Energie. Durch eine Variation des Magnetfelds wird die effektive Ätzwirkung lokal steuerbar. Durch das Magnetfeld, dessen Feldlinien senkrecht zur Substratoberfläche verlaufen, läßt sich die Dichte der einfallenden geladenen Teilchen am Ort des Substrats erhöhen (Plasmapinch-Effekt).

Mit dem erfindungsgemäßen Verfahren ist es bei Verwendung des erfindungsgemäßen Reaktors – wie gesagt – möglich, das makroskopische, durch Druck, Gasfluß und HF-Leistung bestimmte Brennverhalten des Plasmas vom lokalen Ätzverhalten am Ort der Substrate zu entkoppeln. Das heißt mit anderen Worten, daß das Plasma überwiegend nur als Quelle der reaktiven Teilchen dient, während die Steuerung des Ätzvorgangs erfindungsgemäß direkt am Ort der Substrate erfolgt.

Andere vorteilhafte Ausgestaltungen des erfindungsgemäßen Reaktors und des erfindungsgemäßen Verfahrens sind in den Unteransprüchen definiert.

Die Erfindung wird anhand von durch Zeichnungen erläuterten Ausführungsbeispielen beschrieben. Es zeigen :

Fig. 1 einen schematischen Querschnitt durch eine Ausführungsform der erfindungsgemäßen Anordnung und

Fig. 2 den in der Fig. 1 mit einem Kreis eingerahmten Ausschnitt in vergrößerter Darstellung.

Im Unterschied zu den bekannten Reaktoren zum reaktiven Ionenätzen sind bei dem erfindungsgemäßen Reaktor Mittel vorgesehen, welche es ermöglichen, daß jedes zu ätzende Substrat Magnetfeldern ausgesetzt werden kann, welche auf den Bereich des jeweiligen Substrats beschränkt sind und deren Feldlinien senkrecht und/oder parallel zu den Feldlinien des zwischen Kathode und Anode vorhandenen elektrischen Feldes verlaufen. Die Größe der genannten Mittel sind dabei so dimensioniert, daß alle magnetischen Feldlinien im Bereich der Substratoberfläche entweder parallel oder senkrecht zur Substratoberfläche verlaufen. Die Magnetfelder senkrecht zum elektrischen Feld werden beispielsweise mittels eines Permanentmagneten oder mittels einer Spule und die Magnetfelder parallel zum elektrischen Feld beispielsweise mittels einer Spule erzeugt werden. Die genannten Mittel zur Erzeugung der Magnetfelder sind unterhalb der Substrate angeordnet.

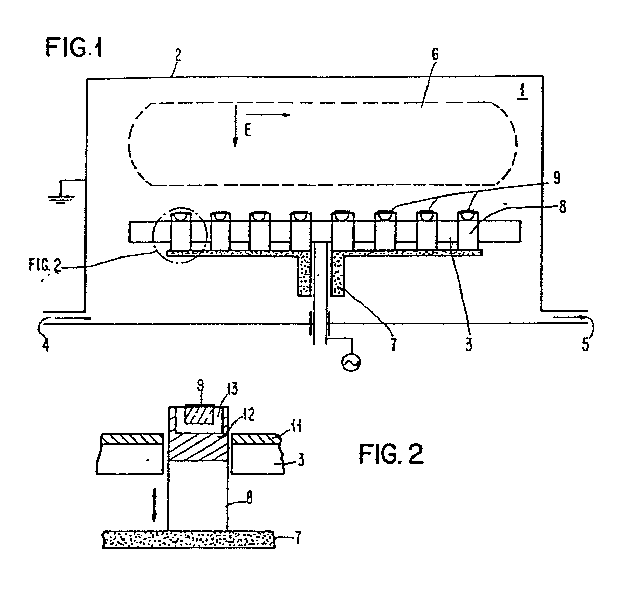

Eine Ausführungsform des erfindungsgemäßen Reaktors, welcher noch ein zusätzliches Merkmal aufweist, soll nun anhand der Fign. 1 und 2 besprochen werden.

Die Fig. 1 zeigt einen Querschnitt durch die Reaktionskammer 1 des Reaktors. Die Reaktionskammer 1 umgibt das Gehäuse 2, welches an Masse liegt. In der Reaktionskammer 1 befindet sich eine plattenförmige, horizontal angeordnete Kathode 3, welche an einer hochfrequenten Wechselspannung liegt. Das Gehäuse 2 dient als Anode des Reaktors. Es ist jedoch auch möglich, eine parallel zur Kathode innerhalb der Reaktions-

3

kammer 1 angeordnete und an Masse oder an einem einstellbaren Potential liegende Platte als Gegenelektrode zu verwenden. Die Reaktionskammer 1 hat mindestens einen Gaseinlaß 4 und einen Gasauslaß 5, durch welchen die Gase in der Reaktionskammer 1 mittels einer (nicht gezeigten) Vakuumpumpe abgesaugt werden. Der Raum, in welchem beim Betrieb des Reaktors das Plasma 6 erzeugt wird, befindet sich zwischen der Kathode und dem oberen, horizontal liegenden Teil des Gehäuses 2 bzw. der Anodenplatte. Mit den Bezugszeichen 7 und 8 sind in der Fig. 1 zwei Teile bezeichnet, welche für eine spezielle Ausführungsform des erfindungsgemäßen Reaktors charakteristisch sind. Mit dem Bezugszeichen 7 ist eine Hebevorrichtung bezeichnet, mit welcher mit dem Bezugszeichen 8 bezeichnete Substrathalter 8, welche in durchgehenden Löchern in der Kathode 3 angeordnet sind, auf und ab bewegt werden können. Auf den Substrathaltern 8 liegen die Substrate 9, welche mittels der Hebevorrichtung 7 von der Kathodenoberfläche in Richtung der Anode angehoben werden können. Die Substrathalter liegen auf einem gleitenden Potential.

Die Fig. 2 zeigt den in der Fig. 1 eingekreisten Bereich in vergrößerter Darstellung. Die Fig. 2 zeigt einen Bereich der Kathode 3 mit einem Loch, in welchem sich ein Substrathalter 8 befindet, welcher auf der Hebevorrichtung 7 aufsteht. Die Oberfläche der Kathode 3 ist mit einer bevorzugt mehrere Millimeter dicken Schicht aus einem dielektrischen Material, bei welchem es sich bevorzugt um Quarz handelt, bedeckt. Auch der Oberteil 12 des Substrathalters 8 besteht aus einem dielektrischen Material, wobei es sich auch bevorzugt um Quarz handelt. In das Oberteil 12 des Substrathalters 8 sind die Mittel zum Erzeugen des Magnetfelds bzw. der Magnetfelder eingelassen. In der Fig. 2 ist als Beispiel der genannten Mittel ein Permanentmagnet in das Oberteil 12 eingesetzt, welcher ein Magnetfeld erzeugt, dessen Feldlinien im Bereich des auf dem Oberteil 12 aufliegenden Substrat 9 parallel zur Kathodenoberfläche verlaufen. Statt des Permanentmagneten 13 kann im Oberteil 12 auch eine Spule, deren Achse parallel zur Kathodenoberfläche liegt, eingebaut sein. Weitere Ausführungsformen des erfindungsgemäßen Reaktors können so ausgestattet sein, daß im Oberteil 12 zur Erzeugung eines Magnetfeldes, dessen Feldlinien senkrecht zur Kathodenoberfläche verlaufen, eine Spule, deren Achse senkrecht zur Kathodenoberfläche ausgerichtet ist oder auch zwei Spulen, von denen die eine ein Magnetfeld mit zur Kathodenoberfläche parallelen Feldlinien und die andere ein Magnetfeld mit zur Kathodenoberfläche senkrecht verlaufenden Feldlinien erzeugen, eingebaut sind. Bei der zuletzt genannten Ausführungsform des erfindungsgemäßen Reaktors kann auch die eine der Spulen durch einen Permanentmagneten ersetzt sein.

Von den bekannten Ätzverfahren mittels reaktiver Ionen unterscheidet sich das erfindungsgemäße Verfahren durch die Anwendung lokaler magnetischer Felder am Ort der zu ätzenden Substrate und die Variation des Abstands zwischen der Oberfläche der kathode und der der Substratauflage.

Wird ein Magnetfeld, dessen Feldlinien parallel zur Kathodenoberfläche verlaufen, mit einer magnetischen Induktion in der Größenordnung von $5 \times 10^{-2}$ T bei sonst gleichen Parametern (Gasfluß, elektrische Leistung, Druck in der Reaktionskammer, Substrattemperatur und Dauer der Ätzung), wie bei den bekannten Verfahren, so erhält man bei nicht angehobenem Substrathalter eine etwa gleich große Erhöhung der Ätzgeschwindigkeit, sowohl bei Materialien, welche bevorzugt physikalisch als auch bei Materialien, welche bevorzugt chemisch geätzt werden. Wird ein Magnetfeld angelegt, dessen Feldlinien parallel zu den Feldlinien des elektrischen Feldes verlaufen und dessen magnetische Induktion auch in der Größenordnung von $5 \times 10^{-2}$ T liegt, so liegt, wenn die übrigen Parameter gleich gewählt werden wie bei den bekannten Verfahren, auch hier die Ätzgeschwindigkeit höher als bei den bekannten Verfahren. Die relative Erhöhung der Ätzgeschwindigkeit ist dabei bei nicht angehobenem Substrathalter bei den überwiegend chemisch ätzbaren Materialien kleiner als bei den überwiegend physikalisch atzbaren Materialien. Werden die Substrate zwei Magnetfeldern gleichzeitig ausgesetzt, deren Feldlinien parallel bzw. senkrecht zum elektrischen Feld verlaufen, und welche beide eine magnetische Induktion in der Größenordnung von $5 \times 10^{-2}$ T haben, so läßt sich auch damit eine Erhöhung der Ätzgeschwindigkeit gegenüber den bei den bekannten Verfahren beisonst gleichen Bedingungen erzielten Geschwindigkeit erzielen. Bei dieser Ausgestaltung des erfindungsgemäßen Verfahrens werden die Ätzgeschwindigkeiten der überwiegend physikalisch ätzbaren und die der überwiegend chemisch ätzbaren Materialien erhöht.

Beim Anheben der Substrate erreicht man, daß durch die Anlegung der Magnetfelder die Ätzgeschwindigkeit der überwiegend chemisch ätzbaren Materialien relativ stärker erhöht wird, als die der überwiegend physikalisch ätzbaren Materialien.

Das erfindungsgemäße Verfahren unter Verwendung des in den Fign. 1 und 2 gezeigten Reaktors wird vor allem angewandt, wenn ein Material, welches überwiegend physikalisch geätzt wird, in Gegenwart eines anderen, welches überwiegend chemisch geätzt wird, bevorzugt geätzt werden soll. Dieser Fall ist beispielsweise dann bedeutungsvoll, wenn beim selektiven Ätzen des überwiegend chemisch atzbaren Materials eine Maske verwendet wird, welche aus dem überwiegend physikalisch zu ätzenden Material besteht, oder wenn eine sehr dünne Schicht aus dem überwiegend physikalisch ätzbaren Material nicht angegriffen werden soll, wenn ein darüber liegendes, überwiegend chemisch atzbares Material geätzt werden soll. Ein Beispiel für den letztgenannten Fall liegt z.B. dann vor, wenn bei der Herstellung eines Feldeffekttransistors, welcher eine Gateoxidschicht aus Siliciumdioxic und ein Polysiliciumgate aufweist, das Gate mittels reaktiven Ionenätzens in einer Chlor und Helium enthaltenden Atmosphäre, in welcher Silicium überwiegend chemisch und Siliciumdioxid überwiegend physikalisch ätzbar sind, die Gatestruktur geätzt werden soll, ohne daß dabei die Gateoxidschicht beachtlich angegriffen werden darf. Was bei diesen Verfahren also besonders wichtig ist, ist ein großes Verhältnis der Geschwindigkeiten, mit der einerseits das chemisch zu ätzende und andererseits das physikalisch zu ätzende Material geätzt werden. Außerdem ist wichtig, daß das überwiegend chemisch ätzbare Material mit in einer fabrikmäßigen Fertigung ausreichender Geschwindigkeit geätzt wird, und daß die Ätzung gleichmäßig erfolgt. Zur genaueren Erläuterung des erfindungsgemäßen Verfahrens unter Verwendung des in den Fign. 1 und 2 gezeigten Reaktors wird im folgenden die Ätzung der Materialkombination Silicium/Siliciumdioxid in einer Chlor und Helium enthaltenden Atmosphäre beschrieben. Es sei jedoch klargestellt, daß das erfindungsgemäße Verfahren sich auch vorteilhaft auf andere Materialkombinationen übertragen läßt, wobei die Auswahl des richtigen Ätzgases bzw. der richtigen Ätzgase im Rahmen des fachmännischen Handelns liegt. Das Ätzgeschwindigkeitenverhältnis beim Ätzen von Silicium und Siliciumdioxid liegt bei Verwendung eines konventionellen Reaktors für das reaktive Ionenätzen bei 10 bis 15. Werden nun die Substrate bei sonst gleichen Bedingungen erfindungsgemäß zusätzlich einem lokalen Magnetfeld bzw. lokalen Magnetfeldern ausgesetzt, so erhöht sich, wie bereits oben ausgeführt worden ist, die Ätzgeschwindigkeit sowohl des überwiegend chemisch ätzbaren Materials, d.h. des Siliciums, als auch des überwiegend physikalisch ätzbaren Materials, d.h. des Siliciumdioxids, um größenordnungsmäßig 10 bis 20%. Werden die Substrate unter denselben Bedingungen wie bei den bekannten Verfahren, d.h. ohne die Anwendung lokaler magnetischer Felder prozessiert, jedoch zusätzlich – bei einem Abstand zwischen Kathode und Anode von ungefähr 8 cm – mittels der Hebevorrichtung 8 ungefähr 20 mm über die Kathodenobefläche angehoben, so stellt man eine sehr starke Reduzierung der Ätzgeschwindigkeiten sowohl von Silicium als auch von Siliciumdioxid fest. Durch die Anlegung lokaler Magnetfelder, und zwar unabhängig davon, ob die magnetischen Feldlinien senkrecht, parallel oder sowohl parallel als auch senkrecht zu den elektrischen Feldlinien verlaufen, erhält man wieder eine Erhöhung der Ätzgeschwindigkeiten, und zwar ist es so, daß die Ätzgeschwindigkeit des Siliciums durch ein Magnetfeld, dessen magnetische Induktion in der Größenordnung von $5 \times 10^{-2}$ T liegt, wieder auf Werte angehoben werden kann, welche nur unwesentlich unter denen liegen, welche bei Anwendung der konventionellen Verfahren, d.h. ohne die Anwendung lokaler Magnetfelder und ohne die Anhebung der Substrate über die Kathodenoberfläche erzielt worden sind. Anders beim Siliciumdioxid, dessen Ätzgeschwindigkeit durch die lokalen Magnetfelder von dem niedrigen, in der angehobenen Stellung, aber ohne angelegtes Magnetfeld gemessenen Wert nur auf einen Wert erhöht werden kann, welcher um den Faktor 3 bis 4 kleiner liegt als bei den bekannten Verfahren. Dieses Ergebnis ist sehr vorteilhaft, weil damit ein Verhältnis der Ätzgeschwindigkeiten von Silicium und Siliciumdioxid erzielt wird, welches zwischen 40 und 50 liegt, ohne daß dabei eine geringere Ätzgeschwindigkeit beim Silicium und eine Einbuße an Homogenität in Kauf genommen werden muß. Als Folge dieses Ergebnisses ist es möglich, Maskierungsschichten aus Siliciumdioxid beim Ätzen von Silicium wesentlich dünner zu machen, was sich in vorteilhafter Weise so auswirkt, daß man Musterelemente mit gröberer Mustertreue in die Siliciumdioxidmaske übertragen kann, und außerdem wird die Gefahr, daß Gateoxidschichten beim Strukturieren von Polysiliciumgates beachtlich angegriffen werden auf ein Minimum reduziert.

Im folgenden wird das erfindungsgemäß unter Verwendung des in den Fign. 1 und 2 gezeigten Reaktors durchgeführte Verfahren anhand von neun Beispielen näher erläutert, bei welchen das erfindungsgemäße Verfahren auf mit einer Siliciumdioxidschicht selektiv maskierten Siliciumwafern angewandt wird. Bei allen neun Beispielen waren die folgenden Verfahrensparameter dieselben :

Helium-Chlorgemisch mit 50 ml Helium und 5 ml Chlor/min. ; *)

leistung 1000 Watt ;

Druck ungefähr 1,3 µbar ;

Zeit 100 Minuten ;

Substrattemperatur : ungefähr

Raumtemperatur ;

Elektrodenabstand ca. 8 cm

*) unter Standardbedingungen

Diejenigen Parameter, welche sich bei den neun Beispielen unterscheiden, sowie die erzielten Ätzgeschwindigkeiten bzw. die erzielten Ätzgeschwindigkeitenvehältnisse sind in der folgenden Tabelle aufgelistet.

EP 0 090 067 B2

| Nr. | Substratabstand zur Kathodenoberfläche [mm] | Magnetfeld $\vec{H}$ ($\perp$ zum $\vec{E}$) | ($\parallel$ zum $\vec{E}$) | Ätzgeschwindigkeit [nm/Min.] Si | SiO$_2$ | Ätzgeschwindigkeitsverhältnis Si: SiO$_2$ |
|---|---|---|---|---|---|---|
| 1 | 0 | − | − | 50 | 3,5 | 10 − 15 |
| 2 | 8 | − | − | 52 | *) | |
| 3 | 20 | − | ~ | 1 | −2,6/−3,2 | |
| 4 | 0 | + | − | 58 | 4 | 14,5 |
| 5 | 8 | + | − | *) | 1,0 | |
| 6 | 20 | + | − | 43 | −1,2 | 40 − 50 |
| 7 | 0 | − | + | 65 | 7 | 8 − 10 |
| 8 | 8 | − | + | 61 | 6 | 8 − 10 |
| 9 | 20 | − | + | 47 | 1,3 | 36 |

*) kein Meßwert ermittelt

EP 0 090 067 B2

Die abgetragenen Silicium- und SiliciumdioxidSchichtdicken wurden interferometrisch bzw. mittels eines mechanisch arbeitenden Stufenmeßgeräts ermittelt und daraus die Ätzgeschwindigkeiten bestimmt. Es wurde außerdem festgestellt, daß die Gleichmäßigkeit der Ätzung gleich gut war wie bei der Anwendung der bekannten Verfahren unter Verwendung bekannter Reaktoren für das reaktive Ionenätzen. Die Ergebnisse in der Tabelle zeigen, daß ein Anheben der Substrate um etwa 8 mm einen geringen, die Anhebung um 20 mm jedoch einen sehr beachtlichen Effekt hat. Dies dürfte darauf zurückzuführen sein, daß bei einer Anhebung um 20 mm die Substrate sich bereits oberhalb des Dunkelraums befinden. Im Dunkelraum findet ein großer Spannungsabfall statt, welcher den in Richtung der Kathode liegenden ionisierten Teilchen eine große kinetische Energie vermittelt. Substrate, welche sich oberhalb des Dunkelraums befinden, sind deshalb Teilchen mit einer wesentlich geringeren kinetischen Energie ausgesetzt als Substrate, welche direkt auf der Kathode aufliegen oder nur wenige mm aus der Ebene der Kathodenoberfläche herausgehoben sind. Die geringe kinetische Energie der ionisierten Teilchen und auch die geringere Elektronendichte oberhalb des Dunkelraums bewirkt offensichtlich beim Beispiel 3 die festgestellte geringe Ätzgeschwindigkeit des Siliciums und die Überkompensation des Ätzens durch eine Wiederabscheidung schon entfernter Teilchen beim Siliciumdioxid. Die Tabelle (siehe Beispiele 6 und 9) zeigt aber auch, daß lokale magnetische Felder mit magnetischen Feldlinien, welche parallel oder senkrecht zu den elektrischen Feldlinien verlaufen, deren magnetische Induktion in der Größenordnung von $5 \times 10^{-2}$ T liegt, die Geschwindigkeit, mit welcher das Siliciun; geätzt wird, wieder auf einen Wert anhebt, welcher nur wenig unter dem liegt, welcher an direkt auf der Kathodenoberfläche liegenden, keinem magnetischen Feld ausgesetzten Substraten gemessen worden ist. Nicht so stark wirken sich aber – wie die Beispiele 6 und 9 auch zeigen – die Magnetfelder auf die Geschwindigkeit, mit welcher das überwiegend physikalisch ätzbare Siliciumdioxid geätzt wird, aus, was zu dem erwünschten Ergebnis führt, daß das Silicium 40 bis 50 mal schneller geätzt wird als das Siliciumdioxid. Die anderen Ergebnisse in der Tabelle (siehe Beispiele 4, 5, 7 und 8) bestätigen die weiter oben diskutierten Wirkungen der lokalen Magnetfelder auf die Substrate, auch in den Fällen, in welchen die Substrate nicht aus der Ebene der Kathode herausgehoben werden.

## Ansprüche

1. Reaktor zum reaktiven Ionenätzen von Substraten mit einer Reaktionskammer (1), welche von einem geerdeten und mindestens einen Gaseinlaß und einen Gasauslaß aufweisenden Gehäuse (2) umgeben ist, in welchem eine plattenförmige, an einer hochfrequenten Wechselspannung liegende Kathode (3), über welcher sich der Raum befindet, in welchem das Plasma (6) aufrechterhalten wird, und gegebenenfalls eine – der Kathode (3) gegenüber an einem einstellbaren Potential liegende Gegenelektrode horizontal angeordnet sind, wobei unter den Substraten Mittel zum Erzeugen eines in den Raum über der Kathode (3) hineinreichenden, magnetischen Feldes angebracht sind, dadurch gekennzeichnet, daß die Kathode (3) Löcher aufweist, in welchen senkrecht zur Substratoberfläche verschiebbare, von der Kathode (3) elektrisch isolierte Substrathalter (8) für je ein Substrat (9) angeordnet sind, daß die Mittel zum Erzeugen der Magnetfelder in den Substrathaltern (8) untergebracht sind und daß das von diesen Mitteln erzeugte magnetische Feld auf den Bereich des jeweiligen Substrats beschränkt ist.

2. Reaktor nach Anspruch 1, dadurch gekennzeichnet, daß die Mittel zum Erzeugen der Magnetfelder so angeordnet und so in Bezug auf die Größe der Substrate (9) dimensioniert sind, daß die auf die Substrate (9) einwirkenden magnetischen Feldlinien senkrecht und/oder parallel zur Substratoberfläche verlaufen.

3. Reaktor nach Anspruch 1 oder 2, dadurch gekennzeichnet, daß eine Hebevorrichtung (7) vorhanden ist, die alle Substrathalter (8) gemeinsam anheben kann.

4. Reaktor nach einem der Ansprüche 1 bis 3, dadurch gekennzeichnet, daß die Kathode (3) mit einer Quarzplatte (11) abgedeckt ist und das Oberteil (12) der Substrathalter (8) aus Quarz besteht.

5. Verfahren zum Ätzen von Substraten (9) unter Verwendung eines Reaktors nach einem der Ansprüche 1 bis 4, bei dem die Substrate (9) den in einem aus einem reaktiven Gas erzeugten Plasma hergestellten, ionisierten Teilchen ausgesetzt sind, dadurch gekennzeichnet, daß das makroskopische Brennverhalten des Plasmas von der lokalen Ätzwirkung auf die Substrate mit Hilfe eines die Ladungsträgerbahnen beeinflussenden Magnetfeldes abgekoppelt wird und daß beim Ätzen eines überwiegend chemisch ätzbaren Materials in Gegenwart eines überwiegend physikalisch ätzbaren Materials die Substrate (9) über die Ebene der Kathodenoberfläche angehoben werden.

6. Verfahren nach Anspruch 5, dadurch gekennzeichnet, daß die Substrate (9) während des Ätzens je einem lokalen Magnetfeld mit zu den elektrischen Feldlinien senkrecht verlaufenden Feldlinien und/ oder einem lokalen Magnetfeld mit zu den elektrischen Feldlinien parallel verlaufenden Feldlinien ausgesetzt sind.

7. Verfahren nach Anspruch 5 oder 6, dadurch gekennzeichnet, daß die Substrate (9) über die Ebene der Kathodenoberfläche so hoch angehoben werden, daß sie sich oberhalb des Dunkelraums über der Kathode-

7

noberfläche befinden.

8. Verfahren nach einem der Ansprüche 5 bis 7, dadurch gekennzeichnet, daß bei einem Abstand zwischen Kathode (3) und Anode (2) von ungefähr 8 cm die Substrate ungefähr 20 mm über die Kathodenoberfläche angehoben werden.

9. Verfahren nach einem der Ansprüche 5 bis 8, dadurch gekennzeichnet, daß Silicium in Gegenwart von Siliciumdioxid mittels eines Helium und Chlor enthaltenden Gemisches geätzt wird.

10. Verfahren nach einem der Ansprüche 5 bis 9, dadurch gekennzeichnet, daß Silicium in Gegenwart von Siliciumdioxid bei einem Gasfluß von 50 ml Helium und 5 ml Chlor pro Minute, einen Druck in der Reaktionskammer von ungefähr 1,3 µbar, einer HF-Leistung von 1000 Watt und unter Anlegung mindestens eines Magnetfeldes, dessen magnetische Flußdichte in der Größenordnung von $5 \times 10^{-2}$ T liegt, geätzt wird.

## Claims

1. Reactor for the reactive ion etching of substrates, with a reaction chamber (1) surrounded by a grounded casing (2) having at least one gas inlet and one gas outlet and containing a plate-shaped cathode (3), connected to a high-frequency AC voltage, above which the space for sustaining the plasma (6) is provided, and, if necessary, opposite cathode (3), a horizontally arranged counterelectrode connected to an adjustable potential, wherein, below the substrate, means are provided for producing a magnetic field reaching into the space above the cathode (3), characterized in that the cathode (3) has holes in which substrate holders (8), vertically displaceable relative to the substrate surface and electrically insulated from the cathode (3), are arranged for one substrate (9) each, that the means for producing the magnetic fields are accommodated in the substrate holders (8), and that the magnetic field produced by said means is limited to the area of the respective substrate.

2. Reactor as claimed in claim 1, characterized in that the means for producing the magnetic fields are arranged and dimensioned such relative to the size of the substrates (9) that the magnetic field lines acting on the substrates (9) extend vertically and/or in parallel to the substrate surface.

3. Reactor as claimed in claim 1 or 2, characterized in that there is a lifting device (7) capable of jointly lifting all substrate holders (8).

4. Reactor as claimed in any one of the claims 1 to 3, characterized in that the cathode (3) is covered by a quartz plate (11), and the upper part (12) of the substrate holders (8) consists of quartz.

5. Method of etching substrates (9) using a reactor as claimed in any one of the claims 1 to 4, wherein the substrates (9) are exposed to the ionized particles produced in a plasma generated from a reactive gas, characterized in that the macroscopic burning behaviour of the plasma is decoupled from the local etch effect on the substrates by a magnetic field influencing the charge carrier paths, and that during etching of a predominantly chemically etchable material in the presence of a predominantly physically etchable material the substrates (9) are lifted above the plane of the cathode surface.

6. Method as claimed in claim 5, characterized in that, during etching, the substrates (9) are exposed to one local magnetic field each with field lines extending vertically to the electrial field lines and/or a local magnetic field with field lines extending in parallel to the electrical field lines.

7. Method as claimed in claim 5 or 6, characterized in that the substrates (9) are lifted above the plane of the cathode surface by such an amount that they are above the dark space over the cathode surface.

8. Method as claimed in any one of the claims 5 to 7, characterized in that at a spacing of about 8 cm between the cathode (3) and the anode (2), the substrates are lifted about 20 mm above the cathode surface.

9. Method as claimed in any one of the claims 5 to 8, characterized in that silicon in the presence of silicon dioxide is etched by means of a mixture containing helium and chlorine.

10. Method as claimed in any one of the claims 5 to 9, characterized in that silicon in the presence of silicon dioxide is etched using a gas flow of 50 ml helium and 5 ml chlorine per minute, a pressure in the reaction chamber of about 1.3 µbar, an HF power of 1000 Watt, and applying at least one magnetic field having a magnetic flux density of the order of $5 \times 10^{-2}$.

## Revendications

1. Réacteur pour la gravure ionique réactive de substrats, comportant une chambre de réaction (1), qui est entourée par une enceinte (2) raccordée à la terre et comportant au moins une entrée de gaz et une sortie de gaz, où sont disposées horizontalement une cathode (3) en forme de plaque, soumise à une tension alternative de haute fréquence et au-dessus de laquelle est situé l'espace dans lequel le plasma (6) est maintenu, et le cas échéant une contre-électrode soumise – par rapport à la cathode (3) – à un potentiel réglable, des moyens pour produire un champ magnétique pénétrant dans l'espace situé au-dessus de la cathode (3) étant disposés en dessous des substrats, caractérise en ce que la cathode (3) comporte des trous, dans lesquels des supports de substrats (8), isolés électriquement par rapport à la cathode (3) et mobiles par translation perpendiculairement à la surface de substrat ; sont disposés pour chaque substrat (9), en ce que les moyens pour produire les champs magnétiques sont logés dans les supports (8) de substrats et en ce que le champ magnétique produit par ces moyens est limité à la zone du substrat respectif.

2. Réacteur selon la revendication 1, caractérisé en ce que les moyens pour produire les champs magnétiques sont disposés et dimensionnés par rapport à la grandeur des substrats (9) de telle sorte que les lignes de champ magnétique agissant sur les substrats (9) soient orientées perpendiculairement et/ou parallèlement à la surface des substrats.

3. Réacteur selon la revendication 1 ou 2, caractérisé en ce qu'il est prévu un dispositif de levage (7) qui peut soulever ensemble tous les supports de substrat (8).

4. Réacteur selon une des revendications 1 à 3, caractérisé en ce que la cathode (3) est recouverte par une plaque de quartz (11) et la partie supérieure (12) du support de substrats (8) est formée de quartz.

5. Procédé de gravure de substrats (9) en utilisant un réacteur selon une des revendications 1 à 4, selon lequel les substrats (9) sont soumis aux particules ionisées formées dans un plasma produit à partir d'un gaz réactif, caractérisé en ce que le comportement macroscopique de brûlage du plasma est découplé de l'effet local de gravure sur les substrats au moyen d'un champ magnétique agissant sur les trajets des porteurs de charge et en ce que, lors de la gravure d'un matériau pouvant être gravé en prépondérance chimiquement en présence d'un matériau pouvant être gravé en prépondérance physiquement, les substrats (9) sont soulevés au-dessus du plan de la surface de cathode.

6. Procédé selon la revendication 5, caractérisé en ce que les substrats (9) sont soumis, pendant la gravure, chacun à un champ magnétique local dont les lignes de champ son orientées perpendiculairement aux lignes de champ électriques et/ou à un champ magnétique local dont les lignes de champ sont orientées parallèlement aux lignes de champ électriques.

7. Procédé selon la revendication 5 ou 6, caractérisé en ce que les substrats (9) sont soulevés au-dessus du plan de surface de cathode suffisamment haut pour qu'ils se trouvent au-dessus de l'espace sombre situé au-dessus de la surface de cathode.

8. Procédé selon une des revendications 5 à 7, caractérisé en ce que, dans le cas d'un espacement d'environ 8 cm entre la cathode (3) et l'anode (2), les substrats sont soulevés à environ 20 mm au-dessus de la surface de cathode.

9. Procédé selon une des revendications 5 à 8, caractérisé en ce que du silicium est gravé en présence de dioxyde de silicium au moyen d'un mélange contentant de l'hélium et du chlore.

10. Procédé selon une des revendications 5 à 9, caractérisé en ce que du silicium est gravé en présence de dioxyde de silicium en utilisant un débit de gaz de 50 ml d'hélium et de 5 ml de chlore par minute, une pression d'environ 1,3 $\mu$bar dans la chambre de réaction, une puissance HF de 1000 watts et avec application d'au moins un champ magnétique dont la densité de flux magnétique est de l'ordre de $5 \times 10^{-2}$ T.

EP 0 090 067 B2

FIG.1

FIG. 2